# EUROPÄISCHE PATENTSCHRIFT

(11) **EP 3 739 757 B1**
(45) Veröffentlichungstag und Bekanntmachung des Hinweises auf die Patenterteilung: **13.03.2024**
(21) Anmeldenummer: 20174041.2
(22) Anmeldetag: 12.05.2020
(51) Int. Cl.: H03K 17/96, H03K 17/97

(54) **OPTIMIERTE SENSORVORRICHTUNG**
OPTIMISED SENSOR DEVICE
DISPOSITIF CAPTEUR OPTIMISÉ

(30) Priorität: 17.05.2019 DE 102019113098
(43) Veröffentlichungstag der Anmeldung: 18.11.2020
(60) Teilanmeldung: 23208106.7
(73) Patentinhaber: Huf Hülsbeck & Fürst GmbH & Co. KG, 42551 Velbert (DE)
(72) Erfinder: Löpke, Christian, 42579 Heiligenhaus (DE); Schmidt, Jens, 40699 Erkrath (DE); Witte, Martin, 48683 Ahaus (DE)
(74) Vertreter: Bals & Vogel Patentanwälte PartGmbB

(56) Entgegenhaltungen:
- DE-A1-102015 109 548
- US-A1- 2016 226 521
- Anonymous: "Redundanz (Technik)", Wikipedia, 20 September 2017 (2017-09-20), XP055929408, Retrieved from the Internet: URL:https://de.wikipedia.org/w/index.php?t itle=Redundanz_(Technik)&oldid=169272464 [retrieved on 2022-06-09]

## Beschreibung

Die Erfindung betrifft ein Verfahren zum Betreiben einer Sensorvorrichtung für eine Betätigung durch eine Deformation eines Bedienkörpers, ein Computerprogrammprodukt, eine Sensorvorrichtung für eine Betätigung durch eine Deformation eines Bedienkörpers sowie ein Fahrzeug.

Aus dem Stand der Technik sind tast- und/oder druckempfindliche Sensoren bekannt. Derartige Sensoren können z.B. bei einem Türgriff eingesetzt werden, um eine Berührung des Türgriffs zu detektieren. Die Drucksensoren sind dabei meist von außen zugänglich oder erfordern ein bewegliches Betätigungselement, wozu z.B. eine Fahrzeugtür entsprechend durchbrochen wird. Dies hat jedoch zur Folge, dass das betroffene Bauteil konstruktiven Einschränkungen unterliegt, die sich insbesondere auch gestalterisch nach außen auswirken und somit die Gestalt des Fahrzeugs negativ beeinträchtigen können.

Aus der DE 10 2016 122 550 A1 ist bspw. ein Sensorsystem zur Aktivierung wenigstens einer Fahrzeugfunktion bekannt, welches hinter einem Blech angeordnet ist und anhand der Deformation des Bleches einen Betätigungswunsch erkennen kann. So ist es denkbar, dass ein Benutzer von außen auf das Blech drückt und der Sensor dies detektiert. Während des Betriebs der Sensorvorrichtung können jedoch Umwelteinflüsse auftreten, welche die Deformation des Bleches beeinflussen und folglich zu Fehlauslösungen führen können. So kann z.B. ein Temperaturwechsel zu unterschiedlichen Spannungszuständen im Blech führen, was ferner Deformationen zur Folge hat, die durch den Sensor ebenfalls detektiert werden können. Es ist wünschenswert derartige Umwelteinflüsse bei der Erkennung eines Betätigungswunsches zu berücksichtigen.

Aus dem Dokument US 2016/0226521 A1 ist ein sogenanntes. "Touch-on-Metal Keypad" für z. B. Tastaturen bekannt, was über eine "Baseline normalization" zur Referenzanpassung der Sensorelemente für die Tasten verfügt. Ferner zeigt das Dokument DE 10 2015 109 548 A1 eine Näherungsschalteranordnung mit kapazitiven Sensoren für Tastschalter im Fahrzeugbereich.

Es ist somit eine Aufgabe der vorliegenden Erfindung voranstehende aus dem Stand der Technik bekannte Nachteile zumindest teilweise zu beheben. Insbesondere ist eine Aufgabe der vorliegenden Erfindung, bei einer Sensorvorrichtung für eine Betätigung durch eine Deformation eines Bedienkörpers das Erkennen und/oder Verarbeiten eines Betätigungswunsches zu verbessern und insbesondere von (ungewollten) Umwelteinflüssen zu unterscheiden.

Die voranstehende Aufgabe wird gelöst durch ein Verfahren mit den Merkmalen des unabhängigen Verfahrensanspruch, ein Computerprogrammprodukt mit den Merkmalen des unabhängigen Computerprogrammprodukt-Anspruchs, eine Sensorvorrichtung mit den Merkmalen des unabhängigen Vorrichtungsanspruchs sowie ein Fahrzeug mit den Merkmalen des unabhängigen Fahrzeuganspruchs. Weitere Merkmale und Details der Erfindung ergeben sich aus den Unteransprüchen, der Beschreibung und den Zeichnungen. Dabei gelten Merkmale und Details die im Zusammenhang mit dem erfindungsgemäßen Verfahren beschrieben worden sind, selbstverständlich auch im Zusammenhang mit dem erfindungsgemäßen Computerprogrammprodukt, der erfindungsgemäßen Sensorvorrichtung und/oder dem erfindungsgemäßen Fahrzeug und jeweils umgekehrt, sodass bzgl. der Offenbarung zu den einzelnen Erfindungsaspekten stets wechselseitig Bezug genommen wird bzw. werden kann.

Erfindungsgemäß umfasst das Verfahren nach Anspruch 1 zum Betreiben einer Sensorvorrichtung für eine Betätigung, insbesondere durch einen Benutzer zum Auslösen einer elektrischen Funktion, durch eine Deformation eines Bedienkörpers die folgenden Schritte:
- Erzeugen zumindest eines Sensorsignals einer Sensorvorrichtung infolge einer (ungewollten / gewollten) Deformation des Bedienkörpers,
- Auswerten des Sensorsignals durch Vergleichen des Sensorsignals mit einer Referenz und Erkennen einer Abweichung des Sensorsignals von der Referenz,
- Anpassen der Referenz an einen Deformationszustands des Bedienkörpers in Abhängigkeit von der Abweichung des Sensorsignals, wobei das Anpassen (105) nur bei einer ungewollten Änderung des Deformationszustandes des Bedienkörpers (2) erfolgt, wobei die ungewollte Änderung des Deformationszustandes durch die Geschwindigkeit der Änderung des Deformationszustandes von einer gewollten Änderung des Deformationszustandes unterschieden wird.

Das Sensorsignal kann vorzugsweise einem Sensorelement der Sensorvorrichtung zugeordnet sein und/oder durch das Sensorelement erzeugt werden. Dabei kann das Sensorsignal ein Messsignal des Sensorelementes umfassen und/oder weiter aufbereitet sein. So kann das Erzeugen des Sensorsignals z.B. umfassen, dass ein Mittelwert eines Messsignals gebildet wird, um das Sensorsignal zu erhalten. Bei der Referenz kann es sich um ein Referenzsignal oder um einen festen Referenzwert handeln. Vorzugsweise ist die Referenz zumindest initial vorgegeben. Das Erkennen der Abweichung des Sensorsignals von der Referenz kann insbesondere das Ergebnis des Vergleichens des Sensorsignals mit der Referenz sein. Auch können mehr als ein Sensorelement bei der Sensorvorrichtung vorgesehen sein. Idealerweise weist jedes Sensorelement ein eigenes Sensorsignal auf.

Unter dem Bedienkörper kann vorzugsweise ein magnetisierbarer und/oder elektrisch leitfähiger Körper, vorzugsweise ein metallischer Körper, verstanden werden. Dabei kann es sich um ein bewegliches Teil eines Fahrzeuges handeln. Es ist jedoch ebenfalls denkbar, dass der Bedienkörper z.B. aus Kunststoff ausgebildet ist und ein metallischer Körper (auch in Form einer metallischen Beschichtung) an dem Bedienkörper angeordnet wird, welcher bei einer Deformation des Bedienkörpers ebenfalls deformiert wird oder zumindest in seiner Position ausgelenkt wird. Das Erzeugen des Sensorsignals kann vorzugsweise induktiv erfolgen, insbesondere durch einen LDC-Sensor. Dadurch kann in vorteilhafter Art und Weise die Deformation des Bedienkörpers erfasst werden.

Vorteilhafterweise kann vorgesehen sein, dass das Anpassen der Referenz an den Deformationszustand während des Erzeugens des Sensorsignals erfolgt. Somit kann im Betrieb dynamisch auf Änderungen des Deformationszustandes reagiert werden. Durch das Auswerten des Sensorsignals wird insbesondere eine Referenznachführung erzielt, durch welche statische und/oder, insbesondere längerfristige, dynamische Spannungszustände (die eine Änderungen des Deformationszustandes bilden) erkannt und von der Auswertung ausgeschlossen werden können. Stellt sich z.B. in Folge einer Temperaturänderung eine Deformation des Bedienkörpers ein, wird die Referenz nachgeführt und das System somit automatisch justiert. Somit kann im Betrieb der Sensorvorrichtung auf Umwelteinflüsse reagiert werden. Beim Anpassen der Referenz an den Deformationszustand kann z.B. die Referenz dem Sensorsignal, insbesondere in einem bestimmten Messpunkt und/oder Mittelwert, gleichgesetzt werden. Vorzugsweise erfolgt das Anpassen der Referenz für dauerhafte Änderungen des Sensorsignals.

Grundsätzlich wird beim Anpassen der Referenz an den (ungewollten / gewollten) Deformationszustand (im Rahmen der Erfindung) zwischen der
a) ungewollten Änderung des Deformationszustandes des Bedienkörpers (ungewollte Deformation) durch äußere unvermeidbare Einflüsse, wie z.B. Umwelteinflüsse (Temperatur-, Druck-, Schallveränderungen) etc., und
b) der gewollten Änderung des Deformationszustandes des Bedienkörpers (gewollte Deformation) durch gewollte Einflüsse durch einen Bediener bei einer Betätigung des Bedienkörpers
unterschieden.

Im Rahmen der Erfindung ist es vorgesehen, dass nur bei der ungewollten Änderung des Deformationszustandes des Bedienkörpers (Fall a)) das Anpassen der Referenz an einen Deformationszustand des Bedienkörpers in Abhängigkeit von der Abweichung des Sensorsignals erfolgt. Die ungewollte Änderung des Deformationszustandes ist messtechnisch durch die Geschwindigkeit der Änderung des Deformationszustandes von der gewollten Änderung des Deformationszustandes deutlich zu unterscheiden. Zusätzlich kann die ungewollte Änderung des Deformationszustandes messtechnisch durch die maximale Änderung des Deformationszustandes innerhalb einer Zeitspanne ΔT von der gewollten Änderung des Deformationszustandes unterschieden werden.

Vorzugsweise kann bei einem erfindungsgemäßen Verfahren vorgesehen sein, dass das Verfahren folgenden Schritt umfasst:
- Ausgeben eines Betätigungssignals zum Ansteuern einer elektrischen Funktion in Abhängigkeit von zumindest einem, insbesondere ersten, Auslösekriterium, insbesondere für die Betätigung,
insbesondere wobei das Betätigungssignal zum Ansteuern einer elektrischen Funktion mit einer Betätigungsamplitude ausgegeben wird, deren Richtung unabhängig von der Referenz ist. Dadurch kann ein eindeutiges Betätigungssignal gesendet werden, welches durch eine Funktionseinheit z.B. eines Fahrzeuges vorteilhaft interpretierbar ist. Das Betätigungssignal kann vorzugsweise ausgegeben werden, wenn der Deformationszustand als Betätigungswunsch erkannt wurde. Dies kann z.B. der Fall sein, wenn das erste Auslösekriterium und/oder weitere Auslösekriterien erfüllt ist/sind. Durch das Auslösekriterium kann insbesondere unterschieden werden, ob es sich bei der Deformation um eine ungewollte (zufällige) Deformation oder einen bewussten Betätigungswunsch (gewollte Deformation) handelt. Zusätzlich zum ersten Auslösekriterium kann vorgesehen sein, dass das Ausgeben des Betätigungssignals zum Ansteuern der elektrischen Funktion in Abhängigkeit von weiteren Auslösekriterien erfolgt. So kann z.B. vorgesehen sein, dass das erste Auslösekriterium zwar ausreicht, um das Anpassen der Referenz, insbesondere die Referenznachführung, anzuhalten, jedoch noch nicht um ein Betätigungssignal auszugeben. Dadurch kann in einfacher Art und Weise es ermöglicht sein, einen Betätigungswunsch anhand einer Deformation an einem Bedienkörper zu erkennen und von ungewollten Deformationen zu unterscheiden. Das erste Auslösekriterium kann zeitabhängig sein, so dass z.B. eine Änderung der Referenz und/oder des Sensorsignals in einer vorbestimmten Zeitspanne durch das erste Auslösekriterium berücksichtigt wird.

Im Rahmen der Erfindung kann ferner vorgesehen sein, dass mehrere, vorzugsweise drei oder vier, Sensorsignale in Folge der Deformation erzeugt werden und für jedes der Sensorsignale das Auswerten, insbesondere des jeweiligen Sensorsignals, durchgeführt wird. Das Ausgeben des Betätigungssignals zum Ansteuern der elektrischen Funktion erfolgt vorzugsweise, wenn jedes der Sensorsignale zumindest das erste Auslösekriterium erfüllt. Durch mehrere Sensorsignale kann eine weitere Verbesserung der Genauigkeit des Verfahrens beim Erkennen des Betätigungswunsches erzielt werden. So können z.B. drei Sensorelemente in einer Reihe angeordnet sein, um die Sensorsignale zu erzeugen. Dadurch ist in besonders vorteilhafter Weise eine Betätigung im Bereich des mittleren Sensorelementes erfassbar, da hier die größte Deformation des Bedienkörpers zu erwarten ist, wenn ein bewusster Betätigungswunsch vorliegt. Vier Sensorelemente können z.B. in einem Quadrat angeordnet werden, um ebenfalls eine eindeutige Mittelposition zu erhalten und die Genauigkeit beim Erkennen des Betätigungswunsches zu verbessern. Dadurch dass jedes der Sensorsignale insbesondere separat ausgewertet wird, kann für jedes der Sensorsignale der Deformationszustand des Bedienkörpers lokal für das jeweils zugeordnete Sensorelement berücksichtigt werden. So ist es denkbar, dass es an unterschiedlichen Positionen im Bereich der Sensorvorrichtung aufgrund lokaler Temperaturänderungen, Wind und/oder dergleichen lokale Deformationszustände auftreten, sodass für jedes Sensorsignal eine unterschiedliche Anpassung der Referenz sinnvoll ist. Dass jedes der Sensorsignale zumindest das erste Auslösekriterium erfüllen kann, umfasst, dass z.B. für jedes der Sensorsignale ein eigener Referenzgrenzwert durch das jeweilige Sensorsignal überschritten wird. Somit kann es sich bei dem Auslösekriterium auch um ein abstraktes Auslösekriterium handeln, welches für jedes der Sensorsignale eigene, konkrete Bedingungen umfasst.

Ferner kann im Rahmen eines erfindungsgemäßen Verfahrens vorgesehen sein, dass das Auswerten des Sensorsignals nach einer vorbestimmten Zeitspanne, insbesondere für die vorbestimmte Zeitspanne, automatisch erneut durchgeführt wird und/oder dass nach einer vorbestimmten Zeitspanne ein Kalibrieren der Sensorvorrichtung erfolgt. Die vorbestimmte Zeitspanne kann z.B. größer einer Minute, vorzugsweise zwei Minuten, betragen. So kann z.B. vorgesehen sein, dass innerhalb der vorbestimmten Zeitspanne die Referenz unangepasst bleibt und erst nach der vorbestimmten Zeitspanne angepasst wird. Dadurch kann ein Energieaufwand durch häufige Auswertungsoperationen geringgehalten werden. Das Kalibrieren der Sensorvorrichtung kann das Anpassen der Referenz und/oder das Anpassen weiterer Randbedingungen in Abhängigkeit von dem Deformationszustand umfassen. Ferner kann vorgesehen sein, dass beim erneuten Durchführen der Auswertung des Sensorsignals die Referenz zunächst wieder auf einen vorbestimmten Ausgangswert zurückgesetzt wird, um durch den Vergleich des Sensorsignals mit der Referenz anschließend neu angepasst zu werden.

Weiterhin ist es bei einem erfindungsgemäßen Verfahren denkbar, dass die Auswertung des Sensorsignals für einen Zug- und/oder Druckzustand der Deformation durchgeführt wird. So ist es denkbar, dass das Signal für unterschiedliche Abweichungsrichtungen von der Referenz ausgewertet werden kann. Eine negative Abweichungsrichtung kann z.B. auf einen Druckzustand des Bedienkörpers zurückgeführt werden, eine positive Abweichungsrichtung auf einen Zugzustand des Bedienkörpers. Im Zugzustand kann der Bedienkörper von der Sensorvorrichtung bereichsweise entfernt sein und im Druckzustand der Sensorvorrichtung angenähert sein. Durch die Auswertung des Zug- und/oder Druckzustandes kann weiterhin eine verbesserte Genauigkeit erzielt werden, insbesondere da eine bewusste Betätigungshandlung einen bestimmten Zustand des Bedienkörpers, z.B. einen Druckzustand, umfassen kann. Wird ein ähnliches Sensorsignal im Zugzustand erkannt, kann somit ein Betätigungswunsch ausgeschlossen werden. Darüber hinaus ist es denkbar, dass bei mehreren Sensorsignalen Zug- und/oder Druckzustände erkannt werden und aus der Kombination der Zug- und/oder Druckzustände der jeweils zugeordneten Sensorsignale darauf geschlossen werden kann, ob es sich um eine bewusste Betätigung handelt.

Im Rahmen der Erfindung ist es ferner denkbar, dass es beim Erzeugen des Sensorsignals eine zeitabhängige Messauswertung durchgeführt wird, insbesondere bei welcher das Sensorsignal in Abhängigkeit von der Signalfrequenz erzeugt wird. Insbesondere kann somit nicht nur die Auswertung des Sensorsignals zeitabhängig sein, sondern auch bereits die Erzeugung. So ist es denkbar, dass eine Anzahl an Null-Durchgängen und/oder Durchgängen durch die Referenz eines Messsignals über eine bestimmte Zeit gezählt wird und dieser Wert durch das Sensorsignal repräsentiert wird. Ferner ist es denkbar, dass lediglich solche Sensorsignale berücksichtigt werden, die eine hohe oder niedrige Dynamik aufweisen. Dies kann ein zusätzliches Kriterium für eine bewusste Betätigung der Sensorvorrichtung bzw. des Bedienkörpers sein.

Weiterhin ist es bei einem erfindungsgemäßen Verfahren denkbar, dass das erste Auslösekriterium zumindest einen Referenzgrenzwert umfasst, ab welchem das Anpassen der Referenz unterbrochen wird, insbesondere so dass eine Signalamplitude des Sensorsignals ausgehend vom Referenzgrenzwert erfasst wird. Insbesondere kann der Referenzgrenzwert zeitabhängig sein und eine Änderung des Sensorsignals und/oder der Referenz insbesondere in einer bestimmten Zeit umfassen. Durch den Referenzgrenzwert kann das erste Auslösekriterium somit derart definiert sein, dass erst ab diesem Wert überhaupt eine Folgeauswertung durchgeführt wird, anhand derer das Erkennen eines Betätigungswunsches erfolgt. Somit können durch das Anpassen der Referenz Schwankungen im Deformationszustand des Bedienkörpers ausgeglichen werden und eine Änderung des Deformationszustands über oder unter den Referenzgrenzwert ein erstes Kriterium einer Auslösung bilden.

Vorzugsweise kann bei einem erfindungsgemäßen Verfahren das Ausgeben des Betätigungssignals zum Ansteuern der elektrischen Funktion in Abhängigkeit von zumindest einem, insbesondere zweiten, Auslösekriterium erfolgen. Insbesondere kann dabei das zweite Auslösekriterium erfüllt sein, wenn das Sensorsignal einen Auslöseparameter erreicht. Vorzugsweise kann das, insbesondere zweite, Auslösekriterium und/oder der Auslöseparameter zeitabhängig sein. Dadurch können z.B. schnelle Änderungen und/oder große Steigungen des Sensorelementes erkannt werden. Durch das zweite Auslösekriterium kann somit eine zweite Schwelle gegeben sein, die vom Sensorsignal erreicht wird, bevor eine Auslösung stattfindet. So kann insbesondere vorgesehen sein, dass nach dem ersten Auslösekriterium die Anpassung der Referenz gestoppt wird und nach dem zweiten Auslösekriterium das Ausgeben des Betätigungssignals erfolgt. Das zweite Auslösekriterium kann vorteilhafterweise ober- und/oder unterhalb der Referenz definiert sein. Insbesondere kann das zweite Auslösekriterium auch zwei Grenzwerte umfassen, sodass ein Korridor für das Sensorsignal gebildet ist und beim Verlassen dieses Korridors durch das Sensorsignal die Betätigung erfolgt. Dadurch kann insbesondere unabhängig von der Richtung der Abweichung des Sensorsignals eine Auslösung erfolgen. Somit können Zug- und/oder Druckzustände des Bedienkörpers abgebildet werden.

Es ist bei einem erfindungsgemäßen Verfahren ferner denkbar, dass ein Deaktivierungsparameter vorgegeben wird und das Ausgeben des Betätigungssignals angehalten wird, wenn das Sensorsignal den Deaktivierungsparameter während des Ausgebens des Betätigungssignals erreicht. Vorzugsweise kann der Deaktivierungsparameter zeitabhängig sein. Dadurch können z.B. schnelle Änderungen und/oder große Steigungen des Sensorelementes erkannt werden. Der Deaktivierungsparameter kann insbesondere dann aktiviert werden, wenn ein Ausgeben des Betätigungssignals erfolgt. Ferner kann der Deaktivierungsparameter gleich dem Auslöseparameter sein. Damit wird eine Einschaltgrenze gleich einer Ausschaltgrenze gesetzt. Es ist jedoch ebenfalls denkbar, dass sich der Deaktivierungsparameter vom Auslöseparameter unterscheidet, insbesondere dass der Deaktivierungsparameter einen größeren Abstand zur Referenz aufweist, als der Auslöseparameter. Dadurch kann die Betätigung bereits dann als gestoppt erkannt werden, wenn noch etwas Deformation nach dem Betätigen zurückbleibt und/oder bevor die Deformation, z.B. durch eine Elastizität des Bedienkörpers, vollständig in den Ausgangzustand zurückgekehrt ist.

Es ist ferner bei einem erfindungsgemäßen Verfahren denkbar, dass der Auslöseparameter und/oder der Deaktivierungsparameter beim Anpassen der Referenz ebenfalls angepasst werden. Dadurch kann insbesondere der gesamte Korridor zum Auslösen für das Sensorsignal verschoben werden, sodass kleinere Abweichungen insbesondere in beiden Richtungen von der Referenz toleriert werden. Damit kann eine vollständige Nachjustierung der Detektion erfolgen, sodass der Zustand des Messsystems bzw. des Auswertesystems jederzeit an dynamische Bedingungen im Betrieb angepasst werden kann.

Gemäß einem weiteren Aspekt der vorliegenden Erfindung ist ein Computerprogrammprodukt beansprucht. Das Computerprogrammprodukt umfasst Befehle, die bei einer Ausführung, insbesondere der Befehle und/oder des Programms, durch eine Kontrolleinheit die Kontrolleinheit dazu veranlassen ein erfindungsgemäßes Verfahren auszuführen.

Somit kann das Verfahren insbesondere durch Ausführung der Befehle bzw. des Programms durch die Kontrolleinheit durchgeführt werden. Das Computerprogrammprodukt kann als Anweisungscode in einer Programmiersprache, wie z.B. Java, C++ oder dergleichen implementiert sein. Bei der Kontrolleinheit kann es sich um eine Rechnereinheit, einen Mikroprozessor und/oder dergleichen handeln. Insbesondere kann der Anweisungscode die Kontrolleinheit derart programmieren, dass die gewünschten Funktionen ausgeführt werden. Das Computerprogrammprodukt kann in einem Netzwerk, z.B. dem Internet oder einem lokalen Netzwerk, bereitgestellt werden und/oder herunterladbar sein. Ferner ist es denkbar, dass das Computerprogrammprodukt durch eine oder mehrere elektronische Schaltungen in Hardware oder in beliebig hybrider Form, d.h. mittels Softwarekomponenten und Hardwarekomponenten realisiert werden bzw. sein kann.

Gemäß einem weiteren Aspekt der Erfindung ist eine Sensorvorrichtung nach Anspruch 9 für eine Betätigung, insbesondere durch einen Benutzer zum Auslösen einer elektrischen Funktion, durch eine Deformation eines Bedienkörpers beansprucht. Die Sensorvorrichtung weist ein Sensorelement auf, das zum Erfassen einer Deformation des Bedienkörpers in einem Abstand zum Bedienkörper anordbar ist. Ferner umfasst die Sensorvorrichtung eine Kontrolleinheit zum Auswerten zumindest eines Sensorsignals des Sensorelementes infolge der Deformation. Darüber hinaus weist die Kontrolleinheit eine Auswerteeinheit zum Auswerten des Sensorsignals durch Vergleichen des Sensorsignals mit einer Referenz, insbesondere durch ein Vergleichsmodul der Auswerteeinheit, und Erkennen einer Abweichung des Sensorsignals von der Referenz, insbesondere durch ein Erkennungsmodul der Auswerteinheit, auf. Ferner weist die Kontrolleinheit ein Kompensationsmodul zum Anpassen der Referenz an einen Deformationszustand des Bedienkörpers in Abhängigkeit von der Abweichung auf.

Die Sensorvorrichtung kann insbesondere auch als Betätigungsvorrichtung oder Betätigungserkennungsvorrichtung bezeichnet werden. Vorzugsweise kann vorgesehen sein, dass die Kontrolleinheit, insbesondere das Erkennungsmodul, zum Ausführen eines erfindungsgemäßen Verfahrens ausgebildet ist. Somit bringt eine erfindungsgemäße Sensorvorrichtung die zum Verfahren beschriebenen Vorteile mit sich. Bei dem Sensorelement handelt es sich vorzugsweise um einen LDC-Sensor, insbesondere in Form einer LDC-Spule. Dadurch kann eine induktive Erkennung der Deformation erfolgen, indem bei Veränderung des Abstandes zwischen dem Bedienkörper und dem Sensorelement durch die Deformation induktiv erfasst werden kann. Die Kontrolleinheit kann mit dem Sensorelement ein Modulbauteil bilden oder separat ausgebildet sein. Insbesondere ist es ferner denkbar, dass die Kontrolleinheit in ein zentrales Steuergerät eines Fahrzeugs integriert ist. Somit bringt eine erfindungsgemäße Sensorvorrichtung die gleichen Vorteile mit sich, wie sie ausführlich bereits mit Bezug auf ein erfindungsgemäßes Verfahren beschrieben worden sind. Die Kontrolleinheit kann vorzugsweise einen Prozessor und/oder einen Mikrocontroller erfassen.

Insbesondere kann bei einer erfindungsgemäßen Sensorvorrichtung vorgesehen sein, dass das Kompensationsmodul zum Anpassen der Referenz an den Deformationszustand des Bedienkörpers während des Betriebs der Sensorvorrichtung ausgebildet ist. Somit kann in Abhängigkeit von Temperaturänderungen und daraus folgenden Deformationen des Bedienkörpers und/oder in Abhängigkeit von statischen Spannungszuständen des Bedienkörpers aufgrund von äußeren Randbedingungen die Referenz angepasst werden.

Weiterhin kann im Rahmen der Erfindung vorgesehen sein, dass die Kontrolleinheit ein Ausgabemodul zum Ausgeben eines Betätigungssignals zum Ansteuern einer elektrischen Funktion aufweist. Dadurch kann das Betätigungssignal ausgegeben werden, wenn die Deformation als Betätigungswunsch erkannt wurde.

Ferner kann bei einer erfindungsgemäßen Sensorvorrichtung vorgesehen sein, dass mehrere, vorzugsweise drei oder vier, Sensorelemente vorgesehen sind, die zum Erzeugen jeweils eines Sensorsignals in einem Abstand zum Bedienkörper anordbar sind, wobei die Auswerteeinheit dazu ausgebildet ist für jedes der Sensorsignale das Auswerten des jeweiligen Sensorsignals durchzuführen. Somit kann vorzugsweise jedes der Sensorsignale separat ausgewertet werden. Dadurch ergibt sich der Vorteil, dass für jeden der durch die Sensorelemente abgedeckten Bereiche separat eine Referenzwertnachführung erfolgen kann und/oder der Deformationszustand lokal berücksichtigt werden kann. Drei oder vier Sensorelemente können in vorteilhafter geometrischer Anordnung vorgesehen sein. So ist es denkbar, dass die vier Sensorelemente in einem Quadrat angeordnet werden und/oder die drei Sensorelemente in einer Reihe. Eine symmetrische Anordnung von vier Sensorelementen ermöglicht eine besonders einfache Auswertung. Wenn ferner auch symmetrische Deformationen zu erwarten sind, kann durch drei Sensorelemente z.B. realisiert sein, dass eine Lokalisierung der Deformation erfolgt. Gleichzeitig ist auf dem mittleren Sensorelement die größte Deformation zu erwarten, wenn dieses im Bereich der erwarteten Betätigung angeordnet ist. Die übrigen Sensorelemente können dann zur Verifikation und/oder Plausibilisierung genutzt werden.

Die erfindungsgemäße Sensorvorrichtung kann mit ihren vorhandenen Sensorelementen eine Tastatur, insbesondere (10er) Zahlentastatur oder Buchstaben-Tastatur bilden, wobei vorzugsweise die Anzahl der vorhandenen Sensorelemente geringer (und zwar deutlich geringer) ist als die Anzahl der vorhandenen Tasten. So können z.B. mit drei oder vier Sensorelementen der Sensorvorrichtung eine 10er-Tastatur mit 10 Tasten ausgebildet werden, da eine genaue Lokalisation der Deformation / Bestimmung des Druckpunktes der Betätigung durch die Auswertung der Sensorsignale der vorhandenen Sensorelemente erfolgt.

Vorzugsweise kann die Kontrolleinheit bei einer erfindungsgemäßen Sensorvorrichtung ein Speichermodul zum Vorgeben eines Auslöseparameters aufweisen, wobei das Ausgeben des Betätigungssignals durchführbar ist, wenn der Auslöseparameter durch zumindest eines der Sensorsignale erreicht wird. Das Speichermodul kann als flüchtiger oder nicht-flüchtiger Speicher ausgeführt sein. Dadurch kann der Auslöseparameter bei der Herstellung und/oder Montage der Sensorvorrichtung vorgebbar sein und/oder dynamisch im Betrieb angepasst werden.

Ferner ist es denkbar, dass die Kontrolleinheit bei einer erfindungsgemäßen Sensorvorrichtung ein Speichermodul zum Vorgeben eines Deaktivierungsparameters aufweist, wobei das Ausgeben des Betätigungssignals durch das Ausgabemodul unterbrechbar ist, wenn der Deaktivierungsparameter während des Ausgebens des Betätigungssignals durch das Sensorsignal erreicht wird. Durch das Speichermodul kann in einfacher Art und Weise die Vorgabe des Deaktivierungsparameters erfolgen. Dabei kann der Deaktivierungsparameter werkseitig vorgegeben sein oder anlernbar sein, sodass im Speichermodul der Deaktivierungsparameter veränderbar ist. Der Deaktivierungsparameter kann somit eine Halteschwelle für die Betätigung darstellen.

Insbesondere kann bei einer erfindungsgemäßen Sensorvorrichtung vorgesehen sein, dass das Kompensationsmodul dazu ausgebildet ist, den Auslöseparameter und/oder den Deaktivierungsparameter in Abhängigkeit von der Referenz anzupassen. Dadurch kann die Auswertung vollständig dynamisch erfolgen und an die jeweiligen Randbedingungen bzw. an statische Deformationszustände des Bedienkörpers angepasst werden. Auch die Auslösung und/oder die Betätigungszeit kann damit verändert werden. Dadurch ergibt sich eine vorteilhafte Auswertung der Sensorsignale ergibt, die eine genaue Erkennung der Deformation bzw. des Betätigungswunsches ermöglicht.

Weiterhin kann bei einer erfindungsgemäßen Sensorvorrichtung die Auswerteinheit der Kontrolleinheit dazu ausgebildet ist, das Auswerten des Sensorsignals nach einer vorbestimmten Zeitspanne automatisch erneut durchzuführen. Zusätzlich oder alternativ kann die Auswerteinheit dazu ausgebildet sein, dass nach einer vorbestimmten Zeitspanne ein Kalibrieren der Sensorvorrichtung durchzuführen. Somit kann durch die vorbestimmte Zeitspanne ein Intervall vorgegeben sein, welches einerseits eine ständige Anpassung der Referenz nicht notwendig macht und zum anderen eine Anpassung an Randbedingungen ermöglicht. Dadurch eine Auswertung der Randbedingungen bei geringem Energieverbrauch erfolgen.

Gemäß einem weiteren Aspekt der Erfindung ist ein Fahrzeug beansprucht. Das Fahrzeug weist ein bewegliches Teil mit einem deformierbaren Bedienkörper und eine erfindungsgemäße Sensorvorrichtung auf. Vorzugsweise ist durch die Sensorvorrichtung ein Öffnungswunsch eines Benutzers für das bewegliche Teil erkennbar.

Bei dem beweglichen Teil kann es sich z.B. um eine Tür, Heckklappe oder dergleichen des Fahrzeugs handeln. Ebenso ist es denkbar, dass das bewegliche Teil im Innenraum des Fahrzeugs vorgesehen ist und z.B. als Handschuhfachklappe ausgeführt ist. Vorzugsweise ist der deformierbare Bedienkörper metallisch oder weist zumindest einen metallischen Bereich auf. Die Sensorvorrichtung ist insbesondere auf einer dem Benutzer abgewandten Seite des Bedienkörpers am Bedienkörper angeordnet, sodass eine Deformation des Bedienkörpers durch die Sensorvorrichtung sensierbar ist, während die Sensorvorrichtung für den Benutzer zumindest im geschlossenen Zustand des beweglichen Teils nicht sichtbar ist. Somit bringt ein erfindungsgemäßes Fahrzeug die gleichen Vorteile mit sich, wie sie bereits ausführlich mit Bezug auf eine erfindungsgemäße Sensorvorrichtung und/oder ein erfindungsgemäßes Verfahren beschrieben worden sind. Insbesondere kann es sich bei der Kontrolleinheit der Sensorvorrichtung um ein zentrales Steuergerät des Fahrzeugs handeln.

Weitere, die Erfindung verbessernde Maßnahmen ergeben sich aus der nachfolgenden Beschreibung zu einigen Ausführungsbeispielen der Erfindung, welche in den Figuren schematisch dargestellt sind. Dabei ist zu beachten, dass die Figuren nur beschreibenden Charakter haben und nicht dazu gedacht sind die Erfindung in irgendeiner Form einzuschränken. Es zeigen schematisch:
- Fig. 1+2: eine erfindungsgemäße Sensorvorrichtung in einem ersten Ausführungsbeispiel,
- Fig. 3+4: eine erfindungsgemäße Sensorvorrichtung in einem weiteren Ausführungsbeispiel,
- Fig. 5: ein erfindungsgemäßes Fahrzeug mit einer erfindungsgemäßen Sensorvorrichtung
- Fig. 6: ein erfindungsgemäßes Verfahren in schematischer Darstellung der Verfahrensschritte,
- Fig.7: eine Auswertung eines Sensorsignals bei dem erfindungsgemäßen Verfahren, und
- Fig.8: ein Erzeugen des Sensorsignals bei dem erfindungsgemäßen Verfahren.

In den nachfolgenden Figuren werden für die gleichen technischen Merkmale auch von unterschiedlichen Ausführungsbeispielen die identischen Bezugszeichen verwendet.

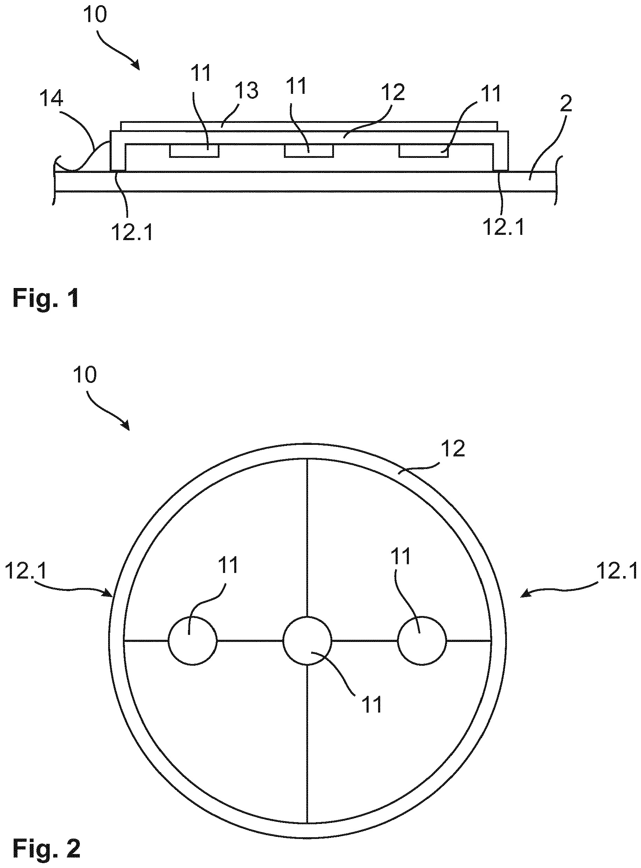

In den Figuren 1 und 2 ist eine erfindungsgemäße Sensorvorrichtung 10 in einem ersten Ausführungsbeispiel dargestellt. Dabei sind bspw. drei Sensorelemente 11 vorgesehen, die über ein Befestigungselement 12 an einem Bedienkörper 2 befestigt sind, wobei jedes der Sensorelemente 11 einen Abstand zum Bedienkörper 2 aufweist. Dazu sind zwei Befestigungsabschnitte 12.1 vorgesehen, mit welchen das Befestigungselement 12 am Bedienkörper 2 befestigt ist. Die Sensorelemente 11 sind zwischen den Befestigungsabschnitten 12.1 reihenartig angeordnet. Eines der Sensorelemente 11 ist dabei mittig vorgesehen, was insbesondere den Betätigungsbereich am Bedienkörper 2 definiert. Gemäß Figur 2 ist gezeigt, dass die Befestigungsabschnitte 12.1 miteinander verbunden sind, insbesondere ineinander übergehen und ringförmig ausgebildet sind. Dadurch können in vorteilhafterweise Deformationen am Bedienkörper 2 erfasst werden. Die Sensorelemente 11 können ein Messsignal 210.1 und/oder ein Sensorsignal 210 generieren, welches über eine Steuerleitung 14 einer Kontrolleinheit 20 zur Verfügung gestellt werden kann. Die Kontrolleinheit 20 kann dabei direkt am Befestigungselement 12 angeordnet sein und auf einer Sensorplatine 13 vorgesehen sein oder kann in ein zentrales Steuergerät eines Fahrzeugs 1 integriert sein. Vorzugsweise ist die Steuerleitung 14 separat vom Befestigungskörper 12 am Bedienkörper 2 befestigbar. Bei den Sensorelementen 11 handelt es sich insbesondere um LDC-Spulen, zu induktiven Messungen des Abstandes des Bedienkörpers 2 zu den Sensorelementen 11. Verringert sich der Abstand durch Deformationen des Bedienkörpers 2 zwischen den Befestigungsabschnitten 12.1 ändert sich das Messsignal 210.1 und/oder das Sensorsignal 210 in charakteristischer Art und Weise.

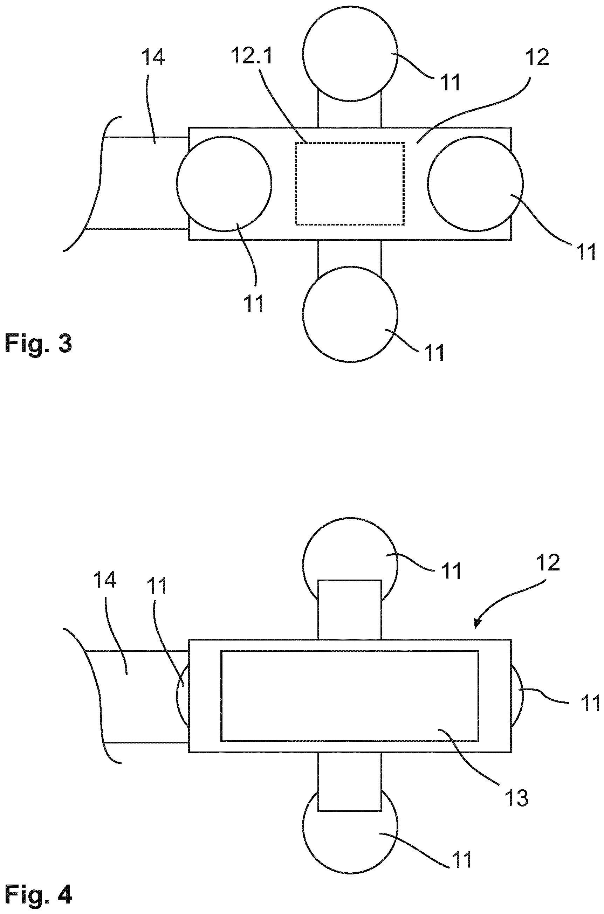

Die Figuren 3 und 4 zeigen ein zweites Ausführungsbeispiel der erfindungsgemäßen Sensorvorrichtung 10 mit vier Sensorelementen 11, die insbesondere quadratisch angeordnet sind. Dabei ist ein Befestigungselement 12 vorgesehen, das die Sensorelemente 11 verbindet und mittig zwischen den Sensorelementen 11 einen Befestigungsabschnitt 12.1 zur Befestigung der Sensorelemente 11 an einem Bedienkörper 2 aufweist. Bei einer Deformation im mittigen Bereich zwischen den Sensorelementen 11 verschieben sich somit die Sensorelemente 11 in Abhängigkeit von der Deformation, insbesondere in Form einer Wölbung, des Bedienkörpers 2, sodass sich der Abstand der Sensorelemente 11 zum Bedienkörper 2 ändert. Auch in diesem Ausführungsbeispiel kann eine Sensorplatine 13 zur zumindest teilweisen Integration einer Kontrolleinheit 20 vorgesehen sein. Zusätzlich oder alternativ kann zumindest eine Steuerleitung 14 vorgesehen sein, um die Sensorvorrichtung 10 z.B. mit einem zentralen Steuergerät eines Fahrzeugs 1 zu verbinden.

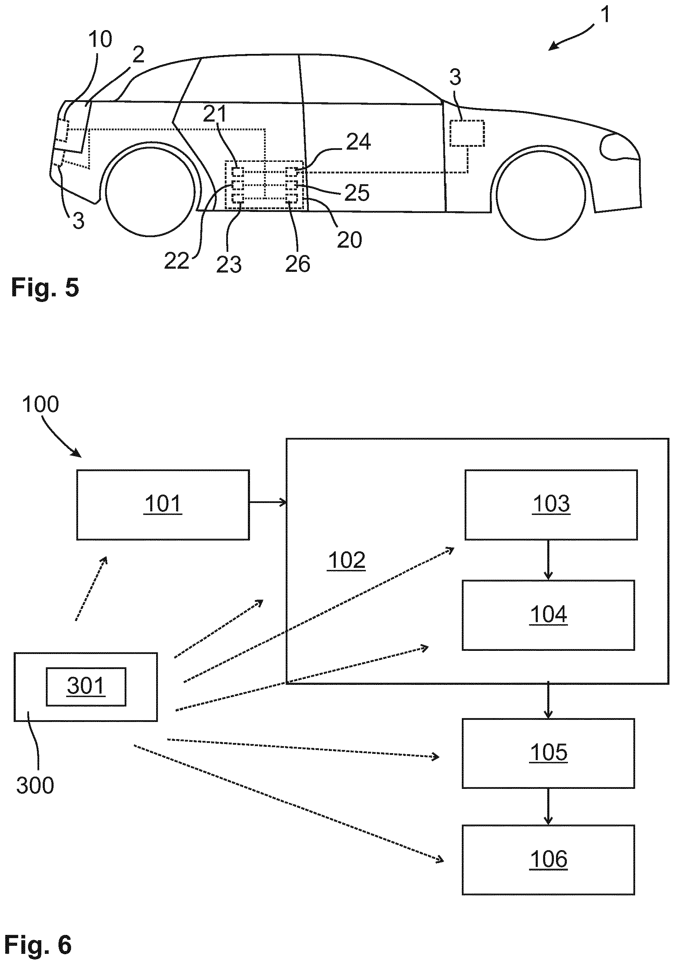

Figur 5 zeigt ein erfindungsgemäßes Fahrzeug 1 mit einer Sensorvorrichtung 10, wobei die Sensorvorrichtung 10 an einem beweglichen Teil des Fahrzeugs 1 in Form einer Heckklappe angeordnet ist. Die Heckklappe bildet somit einen deformierbaren Bedienkörper 2. Wenn man die Sensorvorrichtung 10 betätigt, kann z.B. vorgesehen sein, eine Funktionseinheit 3 des Fahrzeugs anzusteuern. Bei der Funktionseinheit 3 kann es sich z.B. um eine Fahrzeugelektronik zum Ausführen einer Motorstartfunktion, ein Schloss der Heckklappe und/oder dergleichen handeln. Ferner ist eine Kontrolleinheit 20 gezeigt, die vorzugsweise in ein zentrales Steuergerät des Fahrzeugs 1 integriert und/oder zumindest teilweise als Baueinheit mit der Sensorvorrichtung 10 ausgebildet sein kann. Dazu weist die Kontrolleinheit 20 ferner verschiedene Module auf, welche im Folgenden im Zusammenhang mit einem erfindungsgemäßen Verfahren 100 weiter beschrieben werden. Insbesondere kann die Sensorvorrichtung 10 gemäß dem ersten oder zweiten Ausführungsbeispiel ausgebildet sein.

Figur 6 zeigt das Verfahren 100 in schematischer Darstellung der Verfahrensschritte. Dabei ist ferner ein erfindungsgemäßes Computerprogrammprodukt 300 vorgesehen, welches Befehle 301 aufweist, um die Verfahrensschritte des Verfahrens 100 auszuführen. Dazu kann das Computerprogrammprodukt 300 z.B. durch die Kontrolleinheit 20 des in Figur 5 gezeigten Fahrzeugs 1 ausgeführt werden.

Das Verfahren 100 umfasst dabei ein Erzeugen 101 eines Sensorsignals 210 einer Sensorvorrichtung 10, insbesondere eines Sensorelementes 11 der Sensorvorrichtung 10. Das Sensorsignal 210 wird in Folge einer Deformation des Bedienkörpers 2 erzeugt, vorzugsweise wobei sich die Sensorvorrichtung 10 aus Sicht eines Benutzers hinter dem Bedienkörper 2 befindet.

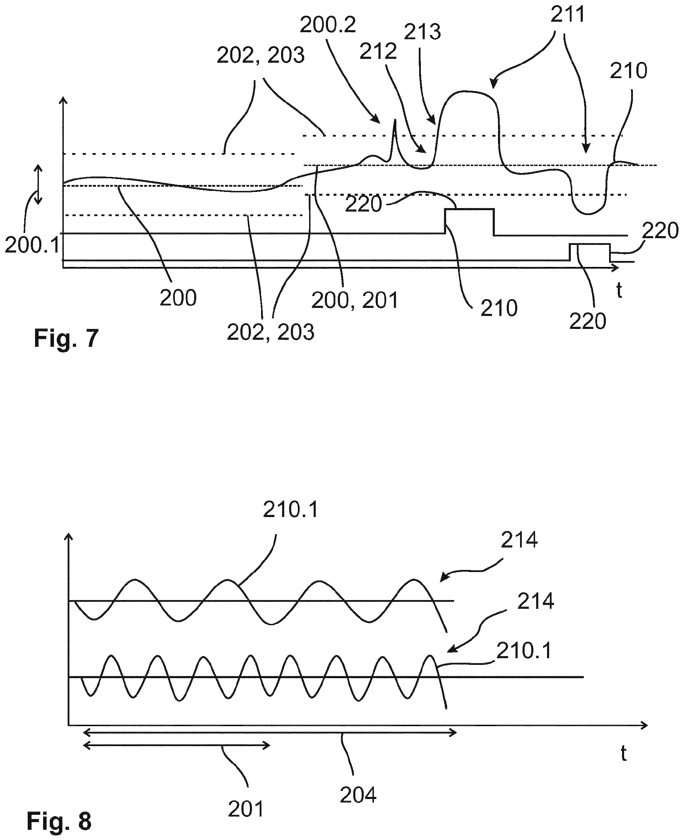

In Figur 8 sind Messsignale 210.1 gezeigt, welche innerhalb einer vorbestimmten Zeitspanne 204 eine bestimmte Anzahl an Null-Durchgängen und/oder eine welche eine bestimmte Sensorfrequenz 214 aufweisen, die insbesondere charakteristisch für ein nicht-betätigtes Sensorelement 11 sind. Das untere Messsignal 210.1 weist eine höhere Sensorfrequenz 214 auf. Dies kann ein Charakteristikum eines betätigten Sensors sein. Aus der Anzahl der NullDurchgänge kann z.B. das Sensorsignal 210 erzeugt werden. Die Anzahl der NullDurchgänge kann sich insbesondere auf einen vorgegebenen Referenzwert beziehen.

Figur 7 zeigt eine Auswertung 102 des Messsignals 210 über eine Zeit t. Dazu weist die Kontrolleinheit 20 zur Ausführung des Verfahrens 100 vorzugsweise eine Auswerteeinheit 21 zum Auswerten 102 des Sensorsignals 210 auf. Dabei ist ein Vergleichen 103 des Sensorsignals 210 mit einer Referenz 200, insbesondere durch ein Vergleichsmodul 22 der Kontrolleinheit 20, vorgesehen. Wird dabei, insbesondere durch ein Erkennungsmodul 23 der Kontrolleinheit 20, eine Abweichung 200.1, insbesondere in Form einer Signalamplitude 211, erkannt, d.h. es erfolgt ein Erkennen 104 der Abweichung 200.1 von der Referenz 200, wird ein Anpassen 105 der Referenz 200, insbesondere durch ein Kompensationsmodul 24 der Kontrolleinheit 20, durchgeführt. Somit ist insbesondere eine Referenzwertnachführung vorgesehen, welche auf Randbedingungen des aktuellen Betriebszustands des Bedienkörpers 2 und/oder der Sensorvorrichtung 10 reagiert. Im dargestellten Ausführungsbeispiel übersteigt das Sensorsignal 210 die Referenz 200 über einen bestimmten Referenzgrenzwert 201. Der Referenzgrenzwert 201 kann, wie in Figur 8 dargestellt, eine Zeitspanne und/oder eine Signalfrequenz 214 umfassen, so dass durch den Referenzgrenzwert 201 ein langsamer Anstieg des Sensorsignals 210 (z.B durch eine ungewollte Deformation) von einem schnellen Anstieg (z.B durch eine gewollte Deformation) unterschieden werden kann. Zusätzlich oder alternativ kann der Referenzgrenzwert 201 einen absoluten Wert oder ein Referenzsignal umfassen, ab welchem das Anpassen 105 der Referenz 200 angehalten wird. Eine Abweichung 200.1 des Sensorsignals 210 von der Referenz 200 vor Erreichen des Referenzgrenzwertes 201 durch das Sensorsignal 210 deutet somit auf eine (ungewollte) Deformation des Bedienkörpers 2 hin, die Randbedingungen geschuldet ist. Dies kann z.B. vorliegen, wenn sich der Bedienkörper 2 aufgrund von Temperaturveränderungen verformt. Weiterhin ist im Rahmen der Auswertung 102 des Sensorsignals 210 ein Entfernen 106 einer Signalstörung 200.2 vorgesehen. Dies kann z.B. durch Filtern und/oder Entprellen des Sensorsignals 210 erfolgen. Wird der Referenzgrenzwert 201 durch das Sensorsignal 210 erreicht, kann ein erstes Auslösekriterium 212 zum Ausgeben 107 eines Betätigungssignals 220 vorliegen. Vorzugsweise ist zumindest ein zweites Auslösekriterium 213 zum Ausgeben 107 eines Betätigungssignals 220 vorgesehen. Das zweite Auslösekriterium 213 kann z.B. vorliegen, wenn das Sensorsignal 210 oberhalb des Referenzgrenzwertes 201 eine hohe Steigung und/oder Änderung aufweist. Übersteigt das Sensorsignal 210 bspw., insbesondere in kurzer Zeit, einen Auslöseparameter 202 erfolgt ein Ausgeben 107 eines Betätigungssignals 220. Wie dargestellt kann das Ausgeben 107 des Betätigungssignals 220 sowohl für positive als auch negative Signalamplituden 211 des Sensorsignals 210 infolge von Deformationen des Bedienkörpers 2 erfolgen, wobei eine Amplitude 221 des Betätigungssignals 220 stets positiv ist, wenn eine Auslösung erfolgt. Dadurch kann eine eindeutige Ansteuerung einer Funktionseinheit 3, insbesondere des Kraftfahrzeugs 1, erfolgen. Erreicht das Sensorsignal 210 infolge nachlassender Deformation anschließend einen Deaktivierungsparameter 203, wird das Ausgeben 107 des Betätigungssignals 220 angehalten. Wie dargestellt, können der Auslöseparameter 202 und der Deaktivierungsparameter 203 übereinstimmen. Es ist jedoch ebenfalls denkbar, dass sich der Auslöseparameter 202 und der Deaktivierungsparameter 203 unterscheiden. Dadurch können z.B. nach der Deformation zumindest zeitweise zurückbleibende Verformungen berücksichtigt werden.

Die voranstehende Erläuterung der Ausführungsform beschreibt die vorliegende Erfindung, ausschließlich im Rahmen von Beispielen.

## Patentansprüche

1. Verfahren (100) zum Betreiben einer Sensorvorrichtung (10) für eine Betätigung durch eine Deformation eines Bedienkörpers (2) umfassend die folgenden Schritte:
- Erzeugen (101) zumindest eines Sensorsignals (210) einer Sensorvorrichtung (10) infolge einer Deformation des Bedienkörpers (2),
- Auswerten (102) des Sensorsignals (210) durch Vergleichen (103) des Sensorsignals (210) mit einer Referenz (200) und Erkennen (104) einer Abweichung (200.1) des Sensorsignals (210) von der Referenz (200),
- Anpassen (105) der Referenz (200) an einen Deformationszustand des Bedienkörpers (2) in Abhängigkeit von der Abweichung (200.1) des Sensorsignals (210), **dadurch gekennzeichnet, dass** das Anpassen (105) nur bei einer ungewollten Änderung des Deformationszustandes des Bedienkörpers (2) erfolgt, wobei die ungewollte Änderung des Deformationszustandes durch die Geschwindigkeit der Änderung des Deformationszustandes von einer gewollten Änderung des Deformationszustandes unterschieden wird.

2. Verfahren (100) nach Anspruch 1,
**dadurch gekennzeichnet,**
**dass** das Verfahren (100) folgenden Schritt umfasst:
- Ausgeben (107) eines Betätigungssignals (220) zum Ansteuern einer elektrischen Funktion in Abhängigkeit von zumindest einem ersten Auslösekriterium (212),
insbesondere wobei das Betätigungssignal (220) zum Ansteuern einer elektrischen Funktion mit einer Betätigungsamplitude (221) ausgegeben wird, deren Richtung unabhängig von der Referenz (200) ist.

3. Verfahren (100) nach einem der Ansprüche 1 oder 2,
**dadurch gekennzeichnet,**
**dass** mehrere, vorzugsweise drei oder vier, Sensorsignale (210) infolge der Deformation erzeugt werden und für jedes der Sensorsignale (210) das Auswerten (102) durchgeführt wird, insbesondere wobei das Ausgeben (107) des Betätigungssignals (220) zum Ansteuern der elektrischen Funktion erfolgt, wenn jedes der Sensorsignale (210) zumindest das erste Auslösekriterium (212) erfüllt.

4. Verfahren (100) nach einem der vorhergehenden Ansprüche,
**dadurch gekennzeichnet,**
**dass** das Auswerten (102) des Sensorsignals (210) nach einer vorbestimmten Zeitspanne (204) automatisch erneut durchgeführt wird und/oder dass nach einer vorbestimmten Zeitspanne (204) ein Kalibrieren der Sensorvorrichtung (10) erfolgt,
und/oder dass die Auswertung (102) des Sensorsignals (210) für einen Zug- und/oder Druckzustand der Deformation durchgeführt wird.

5. Verfahren (100) nach einem der vorhergehenden Ansprüche,
**dadurch gekennzeichnet,**
**dass** beim Erzeugen (101) des Sensorsignals (210) eine zeitabhängige Messauswertung durchgeführt wird, insbesondere bei welcher das Sensorsignal (210) in Abhängigkeit von einer Signalfrequenz (214) erzeugt wird,
und/oder dass das erste Auslösekriterium (212) zumindest einen Referenzgrenzwert (201) umfasst, ab welchem das Anpassen (105) der Referenz (200) unterbrochen wird, insbesondere so dass eine Signalamplitude (211) des Sensorsignals (210) ausgehend vom Referenzgrenzwert (201) erfasst wird.

6. Verfahren (100) nach einem der vorhergehenden Ansprüche,
**dadurch gekennzeichnet,**
**dass** das Ausgeben (107) des Betätigungssignals (220) zum Ansteuern der elektrischen Funktion in Abhängigkeit von zumindest einem zweiten Auslösekriterium (213) erfolgt, insbesondere wobei das zweite Auslösekriterium (213) erfüllt ist, wenn das Sensorsignal (210) einen Auslöseparameter (202) erreicht.

7. Verfahren (100) nach einem der vorhergehenden Ansprüche,
**dadurch gekennzeichnet,**
**dass** ein Deaktivierungsparameter (203) vorgegeben wird und das Ausgeben (107) des Betätigungssignals (220) angehalten wird, wenn das Sensorsignal (210) den Deaktivierungsparameter (203) während des Ausgebens (107) des Betätigungssignals (220) erreicht,
und/oder dass der Auslöseparameter (202) und/oder der Deaktivierungsparameter (203) beim Anpassen (105) der Referenz (200) ebenfalls angepasst werden.

8. Computerprogrammprodukt (300), umfassend Befehle (301), die bei einer Ausführung durch eine Kontrolleinheit (20) die Kontrolleinheit (20) veranlassen, ein Verfahren (100) nach einem der vorhergehenden Ansprüche auszuführen.

9. Sensorvorrichtung (10) für eine Betätigung durch eine Deformation eines Bedienkörpers (2) aufweisend
ein Sensorelement (11), das zum Erfassen einer Deformation des Bedienkörpers (2) in einem Abstand zum Bedienkörper (2) anordbar ist, und
eine Kontrolleinheit (20) zum Auswerten zumindest eines Sensorsignals (210) des Sensorelementes (11) infolge der Deformation,
wobei die Kontrolleinheit (20) eine Auswerteeinheit (21) zum Auswerten (102) des Sensorsignals (210) durch Vergleichen (103) des Sensorsignals (210) mit einer Referenz (200) und Erkennen (104) einer Abweichung (200.1) des Sensorsignal (210) von der Referenz (200) und ein Kompensationsmodul (24) zum Anpassen (105) der Referenz (200) an einen Deformationszustand des Bedienkörpers (2) in Abhängigkeit von der Abweichung (200.1) aufweist,
wobei die Kontrolleinheit (20), zum Ausführen eines Verfahrens (100) nach einem der Ansprüche 1 bis 7 ausgebildet ist.

10. Sensorvorrichtung (10) nach Anspruch 9,
**dadurch gekennzeichnet,**
**dass** die Kontrolleinheit (20) ein Ausgabemodul (25) zum Ausgeben (107) eines Betätigungssignals (220) zum Ansteuern einer elektrischen Funktion aufweist.

11. Sensorvorrichtung (10) nach einem der Ansprüche 9 oder 10,
**dadurch gekennzeichnet,**
**dass** mehrere, vorzugsweise drei oder vier, Sensorelemente (11) vorgesehen sind, die zum Erzeugen (101) jeweils eines Sensorsignals (210) in einem Abstand zum Bedienkörper (2) anordbar sind, wobei die Auswerteeinheit (21) dazu ausgebildet ist, für jedes der Sensorsignale (210) das Auswerten (102) des jeweiligen Sensorsignals (210) durchzuführen.

12. Sensorvorrichtung (10) nach einem der vorhergehenden Ansprüche,
**dadurch gekennzeichnet,**
**dass** die Kontrolleinheit (20) ein Speichermodul (26) zum Vorgeben eines Auslöseparameters (202) aufweist, wobei das Ausgeben (107) des Betätigungssignals (220) durchführbar ist, wenn der Auslöseparameter (202) durch zumindest eines der Sensorsignale (210) erreicht wird,
und/oder dass die Kontrolleinheit (20) ein Speichermodul (26) zum Vorgeben eines Deaktivierungsparameters (203) aufweist, wobei das Ausgeben (107) des Betätigungssignals (220) durch das Ausgabemodul (25) unterbrechbar ist, wenn der Deaktivierungsparameter (203) während des Ausgebens (107) des Betätigungssignals (220) durch das Sensorsignal (210) erreicht wird.

13. Sensorvorrichtung (10) nach einem der vorhergehenden Ansprüche,
**dadurch gekennzeichnet,**
**dass** das Kompensationsmodul (24) dazu ausgebildet ist, den Auslöseparameter (202) und/oder den Deaktivierungsparameter (203) in Abhängigkeit von der Referenz (200) anzupassen,
und/oder dass die Auswerteinheit (21) der Kontrolleinheit (20) dazu ausgebildet ist, das Auswerten (102) des Sensorsignals (210) nach einer vorbestimmten Zeitspanne (204) automatisch erneut durchzuführen und/oder nach einer vorbestimmten Zeitspanne (204) ein Kalibrieren der Sensorvorrichtung (10) die Kontrolleinheit (20) durchzuführen.

14. Sensorvorrichtung (10) nach einem der vorhergehenden Ansprüche,
**dadurch gekennzeichnet,**
**dass** die Kontrolleinheit (20), insbesondere die Auswerteinheit (21), zum Ausführen eines Verfahrens (100) nach einem der Ansprüche 1 bis 7 ausgebildet ist.

15. Fahrzeug (1) aufweisend ein bewegliches Teil mit einem deformierbaren Bedienkörper (2) und eine Sensorvorrichtung (10) nach einem der Ansprüche 8 bis 14, insbesondere wobei durch die Sensorvorrichtung (10) ein Öffnungswunsch eines Benutzers für das bewegliche Teil erkennbar ist.

## Claims

1. A method (100) of operating a sensor device (10) for actuation by deformation of an operating body (2) comprising the following steps:
- Generating (101) at least one sensor signal (210) of a sensor device (10) as a result of a deformation of the operating body (2),
- Evaluating (102) the sensor signal (210) by comparing (103) the sensor signal (210) with a reference (200) and recognizing (104) a deviation (200.1) of the sensor signal (210) from the reference (200),
- Adaptation (105) of the reference (200) to a deformation state of the operating body (2) as a function of the deviation (200.1) of the sensor signal (210), **characterized in that**
the adaptation (105) only takes place in the event of an unintentional change in the deformation state of the operating body (2), the unintentional change in the deformation state being distinguished from an intentional change in the deformation state by the speed of the change in the deformation state.

2. The method (100) according to claim 1,
**characterized in that**
the method (100) comprises the following step:
- Output (107) of an actuation signal (220) for actuating an electrical function as a function of at least one first triggering criterion (212),
in particular wherein the actuation signal (220) for actuating an electrical function is output with an actuation amplitude (221) whose direction is independent of the reference (200).

3. The method (100) according to any one of claims 1 or 2,
**characterized in that**
a plurality of, preferably three or four, sensor signals (210) are generated as a result of the deformation and the evaluation (102) is performed for each of the sensor signals (210), in particular wherein the output (107) of the actuation signal (220) for actuating the electrical function takes place when each of the sensor signals (210) fulfills at least the first triggering criterion (212).

4. The method (100) according to any one of the preceding claims,
**characterized in that**
the evaluation (102) of the sensor signal (210) is carried out again automatically after a predetermined period of time (204) and/or **in that** the sensor device (10) is calibrated after a predetermined period of time (204),
and/or that the evaluation (102) of the sensor signal (210) is performed for a tensile and/or compressive state of the deformation.

5. The method (100) according to any one of the preceding claims,
**characterized in that**
a time-dependent measurement evaluation is carried out when the sensor signal (210) is generated (101), in particular in which the sensor signal (210) is generated as a function of a signal frequency (214),
and/or **in that** the first trigger criterion (212) comprises at least one reference limit value (201), above which the adaptation (105) of the reference (200) is interrupted, in particular so that a signal amplitude (211) of the sensor signal (210) is detected starting from the reference limit value (201).

6. The method (100) according to any one of the preceding claims,
**characterized in that**
the output (107) of the actuation signal (220) for actuating the electrical function takes place as a function of at least one second triggering criterion (213), in particular the second triggering criterion (213) being fulfilled when the sensor signal (210) reaches a triggering parameter (202).

7. The method (100) according to any one of the preceding claims,
**characterized in that**
a deactivation parameter (203) is predetermined and the output (107) of the actuation signal (220) is stopped when the sensor signal (210) reaches the deactivation parameter (203) during the output (107) of the actuation signal (220),
and/or that the triggering criterion (202) and/or the deactivation parameter (203) are also adapted when adapting (105) the reference (200).

8. A computer program product (300) comprising instructions (301) which, when executed by a control unit (20), cause the control unit (20) to execute a method (100) according to any of the preceding claims.

9. Sensor device (10) for actuation by deformation of an operating body (2), comprising
a sensor element (11) which can be arranged at a distance from the operating body (2) for detecting a deformation of the operating body (2), and
a control unit (20) for evaluating at least one sensor signal (210) of the sensor element (11) as a result of the deformation,
wherein the control unit (20) has an evaluation unit (21) for evaluating (102) the sensor signal (210) by comparing (103) the sensor signal (210) with a reference (200) and recognizing (104) a deviation (200.1) of the sensor signal (210) from the reference (200), and a compensation module (24) for adapting (105) the reference (200) to a deformation state of the operating body (2) as a function of the deviation (200.1),
wherein the control unit (20) is designed to carry out a method (100) according to one of claims 1 to 7.

10. Sensor device (10) according to claim 9,
**characterized in that**
the control unit (20) has an output module (25) for outputting (107) an actuation signal (220) for actuating an electrical function.

11. Sensor device (10) according to any one of claims 9 or 10,
**characterized in that**
a plurality of, preferably three or four, sensor elements (11) are provided, each of which can be arranged at a distance from the operating body (2) in order to generate (101) a sensor signal (210), the evaluation unit (21) being designed to carry out the evaluation (102) of the respective sensor signal (210) for each of the sensor signals (210).

12. Sensor device (10) according to one of the preceding claims,
**characterized in that**
the control unit (20) has a memory module (26) for specifying a triggering criterion (202), it being possible to output (107) the actuation signal (220) when the triggering criterion (202) is reached by at least one of the sensor signals (210),
and/or **in that** the control unit (20) has a memory module (26) for specifying a deactivation parameter (203), it being possible for the output (107) of the actuation signal (220) to be interrupted by the output module (25) if the deactivation parameter (203) is reached by the sensor signal (210) during the output (107) of the actuation signal (220).

13. Sensor device (10) according to one of the preceding claims,
**characterized in that**
the compensation module (24) is designed to adapt the triggering criterion (202) and/or the deactivation parameter (203) as a function of the reference (200),
and/or **in that** the evaluation unit (21) of the control unit (20) is designed to automatically carry out the evaluation (102) of the sensor signal (210) again after a predetermined period of time (204) and/or to carry out a calibration of the sensor device (10) of the control unit (20) after a predetermined period of time (204).

14. Sensor device (10) according to one of the preceding claims,
**characterized in that**
the control unit (20), in particular the evaluation unit (21), is designed to carry out a method (100) according to one of claims 1 to 7.

15. Vehicle (1) having a movable part with a deformable operating body (2) and a sensor device (10) according to one of claims 8 to 14, in particular wherein a user's desire to open the movable part can be recognized by the sensor device (10).

## Revendications

1. Procédé (100) pour faire fonctionner un dispositif de capteur (10) pour un actionnement par une déformation d'un corps de commande (2), comprenant les étapes suivantes :
- Générer (101) au moins un signal de capteur (210) d'un dispositif de capteur (10) suite à une déformation du corps de commande (2),
- Évaluer (102) le signal de capteur (210) en comparant (103) le signal de capteur (210) à une référence (200) et en reconnaissant (104) un écart (200.1) du signal de capteur (210) par rapport à la référence (200),
- Adapter (105) la référence (200) à un état de déformation du corps de commande (2) en fonction de l'écart (200.1) du signal de capteur (210), **caractérisé en ce que**
l'adaptation (105) n'a lieu que lors d'une modification non voulue de l'état de déformation du corps de commande (2), la modification non voulue de l'état de déformation étant distinguée d'une modification voulue de l'état de déformation par la vitesse de la modification de l'état de déformation.

2. Procédé (100) selon la revendication 1,
**caractérisé en ce que**
le procédé (100) comprend l'étape suivante :
- Émettre (107) un signal d'actionnement (220) pour commander une fonction électrique en fonction d'au moins un premier critère de déclenchement (212),
en particulier dans lequel le signal d'actionnement (220) est émis pour commander une fonction électrique avec une amplitude d'actionnement (221) dont la direction est indépendante de la référence (200).

3. Procédé (100) selon l'une des revendications 1 ou 2,
**caractérisé en ce que**
plusieurs, de préférence trois ou quatre, signaux de capteur (210) sont générés suite à la déformation et que l'évaluation (102) est effectuée pour chacun des signaux de capteur (210), en particulier l'émission (107) du signal d'actionnement (220) pour commander la fonction électrique étant effectuée lorsque chacun des signaux de capteur (210) remplit au moins le premier critère de déclenchement (212).

4. Procédé (100) selon l'une quelconque des revendications précédentes,
**caractérisé en ce que**
l'évaluation (102) du signal de capteur (210) est à nouveau effectuée automatiquement après un laps de temps prédéterminé (204) et/ou **en ce qu'**un calibrage du dispositif de capteur (10) est effectué après un laps de temps prédéterminé (204),
et/ou **en ce que** l'évaluation (102) du signal de capteur (210) est effectuée pour un état de traction et/ou de compression de la déformation.

5. Procédé (100) selon l'une quelconque des revendications précédentes,
**caractérisé en ce que**
lors de la génération (101) du signal de capteur (210), on effectue une évaluation de mesure en fonction du temps, en particulier dans laquelle le signal de capteur (210) est généré en fonction d'une fréquence de signal (214),
et/ou **en ce que** le premier critère de déclenchement (212) comprend au moins une valeur limite de référence (201) à partir de laquelle l'adaptation (105) de la référence (200) est interrompue, notamment de telle sorte qu'une amplitude de signal (211) du signal de capteur (210) est détectée à partir de la valeur limite de référence (201).

6. Procédé (100) selon l'une quelconque des revendications précédentes,
**caractérisé en ce que**
l'émission (107) du signal d'actionnement (220) pour commander la fonction électrique s'effectue en fonction d'au moins un deuxième critère de déclenchement (213), en particulier le deuxième critère de déclenchement (213) étant satisfait lorsque le signal de capteur (210) atteint un paramètre de déclenchement (202).

7. Procédé (100) selon l'une quelconque des revendications précédentes,
**caractérisé en ce qu'**
un paramètre de désactivation (203) est prédéfini et l'émission (107) du signal d'actionnement (220) est arrêtée lorsque le signal de capteur (210) atteint le paramètre de désactivation (203) pendant l'émission (107) du signal d'actionnement (220),
et/ou **en ce que** le paramètre de déclenchement (202) et/ou le paramètre de désactivation (203) sont également adaptés lors de l'adaptation (105) de la référence (200).

8. Produit programme d'ordinateur (300) comprenant des instructions (301) qui, lorsqu'elles sont exécutées par une unité de contrôle (20), amènent l'unité de contrôle (20) à mettre en oeuvre un procédé (100) selon l'une quelconque des revendications précédentes.

9. Dispositif de capteur (10) pour un actionnement par une déformation d'un corps de commande (2), présentant
un élément de capteur (11) qui peut être disposé à une certaine distance du corps de commande (2) pour détecter une déformation du corps de commande (2), et
une unité de contrôle (20) pour évaluer au moins un signal de capteur (210) de l'élément de capteur (11) suite à la déformation,
l'unité de contrôle (20) présentant une unité d'évaluation (21) pour évaluer (102) le signal de capteur (210) en comparant (103) le signal de capteur (210) à une référence (200) et en reconnaissant (104) un écart (200.1) du signal de capteur (210) par rapport à la référence (200) et un module de compensation (24) pour adapter (105) la référence (200) à un état de déformation du corps de commande (2) en fonction de l'écart (200.1),
l'unité de contrôle (20) étant conçue pour mettre en oeuvre un procédé (100) selon l'une des revendications 1 à 7.

10. Dispositif de capteur (10) selon la revendication 9,
**caractérisé en ce que**
l'unité de contrôle (20) présente un module de sortie (25) pour émettre (107) un signal d'actionnement (220) pour commander une fonction électrique.

11. Dispositif de capteur (10) selon l'une des revendications 9 ou 10,
**caractérisé en ce qu'**
il est prévu plusieurs, de préférence trois ou quatre, éléments de capteur (11) qui peuvent être disposés à une certaine distance du corps de commande (2) pour produire (101) respectivement un signal de capteur (210), l'unité d'évaluation (21) étant conçue pour effectuer l'évaluation (102) du signal de capteur (210) respectif pour chacun des signaux de capteur (210).

12. Dispositif de capteur (10) selon l'une des revendications précédentes,
**caractérisé en ce que**
l'unité de contrôle (20) présente un module de mémoire (26) pour prédéfinir un paramètre de déclenchement (202), l'émission (107) du signal d'actionnement (220) étant réalisable lorsque le paramètre de déclenchement (202) est atteint par au moins l'un des signaux de capteur (210),
et/ou **en ce que** l'unité de contrôle (20) présente un module de mémoire (26) pour prédéfinir un paramètre de désactivation (203), l'émission (107) du signal d'actionnement (220) par le module de sortie (25) pouvant être interrompue lorsque le paramètre de désactivation (203) est atteint par le signal de capteur (210) pendant l'émission (107) du signal d'actionnement (220).

13. Dispositif de capteur (10) selon l'une des revendications précédentes,
**caractérisé en ce que**
le module de compensation (24) est conçu pour adapter le paramètre de déclenchement (202) et/ou le paramètre de désactivation (203) en fonction de la référence (200),
et/ou **en ce que** l'unité d'évaluation (21) de l'unité de contrôle (20) est conçue pour effectuer à nouveau automatiquement l'évaluation (102) du signal de capteur (210) après un laps de temps prédéterminé (204) et/ou pour effectuer un étalonnage du dispositif de capteur (10) après un laps de temps prédéterminé (204) l'unité de contrôle (20).

14. Dispositif de capteur (10) selon l'une des revendications précédentes,
**caractérisé en ce que**
l'unité de contrôle (20), en particulier l'unité d'évaluation (21), est conçue pour mettre en oeuvre un procédé (100) selon l'une des revendications 1 à 7.

15. Véhicule (1) présentant une partie mobile avec un corps de commande déformable (2) et un dispositif de capteur (10) selon l'une des revendications 8 à 14, en particulier dans lequel un souhait d'ouverture de la partie mobile par un utilisateur peut être détecté par le dispositif de capteur (10).
